# EUROPEAN PATENT APPLICATION

(11) **EP 4 492 447 A1**
(43) Date of publication of application: **15.01.2025**
(21) Application number: 23912960.4
(22) Date of filing: 28.12.2023
(51) Int. Cl.: H01L 23/00, H01L 33/62, H01L 33/58, H01L 25/075

(54) **MICRO LED ARRAY ELECTRONIC DEVICE AND MANUFACTURING METHOD THEREFOR**

(30) Priority: 28.12.2022 KR 20220187536
(71) Applicant: Seoul National University R&DB Foundation, Seoul 08826 (KR)
(72) Inventor: HONG, Yong Taek, Seoul 06334 (KR); YOON, Hyung Soo, Seoul 08826 (KR); JEONG, Su Jin, Seoul 08826 (KR)
(74) Representative: TRBL Intellectual Property
(86) International application number: PCT/KR2023/021788
(87) International publication number: WO 2024/144286

(57) **Abstract**

In a micro LED array electronic device presented in one embodiment of the present invention, a micro LED array comprising a plurality of light-emitting elements arranged in columns and rows comprises: two electrodes extended on a substrate in one direction; and a cured polymer including ferromagnetic particles and filling the gap between electronic devices vertically spaced from the electrodes, wherein the interval between the plurality of electronic devices is 5 µm - 100 µm.

## Description

### TECHNICAL FIELD

The present invention relates to an electronic device comprising a micro LED and its transfer method. More specifically, a micro LED transferred using stamping and magnetic field alignment technologies and a manufacturing method thereof.

### BACKGROUND ART

A transfer process is a process of moving electronic devices into a substrate in which other components are arranged, and is a key technology to implement a micro LED display and the like. Conventionally, a pick-and-place transfer process, which is a method of picking up individual electronic devices and placing them on a desired substrate location, was mainly applied.

However, such a pick-and-place transfer process becomes inefficient and unproductive as it becomes more and more high resolution and large area application, as 24 million LED devices should be arranged in a circuit to implement 4K resolution as a background. In addition, as the size of individual electronic devices and the gap between devices become smaller, the precision of a pick-and-place machine should increase, but the mechanical precision of the machine cannot keep up with miniaturization of devices and degree of integration of circuits, and therefore, there are limitations to transferring micro-sized electronic devices by the pick-and place transfer process.

Therefore, methods and processes that can more efficiently transfer micro-sized electronic devices capable of corresponding to high resolution and large area application are required. Including a method using fluid, methods of transferring and aligning micro-sized electronic devices by various method have been studied, but any one of the methods has not been standardized, which becomes a barrier to commercialization.

### DISCLOSURE

### TECHNICAL PROBLEM

An object of the present invention is to solve the afore-mentioned problems, and is to provide a technology of efficiently transferring an electronic device such as a micro LED on an array basis, rather than the conventional pick-and-place transfer process.

However, problems to be solved by the present invention are not limited to those mentioned above, and other problems not mentioned will be clearly understood by those skilled in the art from the description below.

### TECHNICAL SOLUTION

In order to solve the afore-mentioned problems, the micro LED array electronic device suggested in one example of the present invention is a micro LED array comprising a plurality of light emitting devices arranged in columns and rows, which comprises two electrodes formed extending in one direction on a substrate; and cured polymers that fill the gap between the electrodes and vertically spaced electronic devices and comprises ferromagnetic particles, wherein the gap between the plurality of electronic devices is 5 µm or more and 100 µm or less.

According to one example, the gap between the electronic devices may be 35 µm or less.

According to one example, it may further comprise two contact pads formed on the electrode direction surface of the light emitting devices, and the polymers may further comprise dispersed scattering nanoparticles.

According to one example, the scattering nanoparticles may comprise metal oxide.

According to one example, the scattering nanoparticles may be at least one selected from the group consisting of TiO₂, SiO₂, ZnO, Al₂O₃, BaSO₄, CaCO₃ and ZrO₂.

According to one example, the ferromagnetic particles may be oriented and arranged to electrically connect the electrodes and the light emitting devices.

According to one example, the thickness from the substrate to the electronic devices may be 1 mm or less.

According to one example, the polymer curing of the electronic devices may be performed with a single magnet located at the bottom of the substrate.

According to one example, the lateral surface area of the electronic devices may be smaller than the sum of the lateral surface areas of the two electrodes.

The manufacturing method of a micro LED electronic device suggested in another aspect of the present invention may comprise; preparing a first substrate in which a plurality of electronic device arrays are arranged on one side, and a second substrate in which polymers comprising ferromagnetic particles are formed on one side, respectively; contacting the electronic device arrays of the first substrate and the polymers of the second substrate while controlling an approach speed, to coat the electronic device arrays with the polymers; preparing a third substrate in which electrodes corresponding to the electronic device arrays are formed on at least one side; contacting the polymers coated on the electronic device arrays of the first substrate and the electrodes of the third substrate; arranging the ferromagnetic particles in the polymers by forming a magnetic field between the first substrate and the third substrate so that the electronic device arrays and the electrodes are electrically connected; and curing the polymers so that the state of the arranged ferromagnetic particles is fixed, and the gap between the plurality of electronic devices may be 5 µm or more and 100 µm or less.

According to one example, the approach speed may be 10 mm/min to 1500 mm/min.

According to one example, the approach speed may be 50 mm/min or more.

According to one example, it may further comprise; mixing scattering particles to the polymers before the coating the polymers, and the light emitting devices may further comprise a contact pad on the bottom.

According to one example, the arranging the ferromagnetic particles may be performed using a magnet placed only on either the bottom of the third substrate or the top of the first substrate.

According to one example, the arranging the ferromagnetic particles may be performed without placing a magnet on the top of the first substrate.

According to one example, the thickness from the substrate to the electronic devices may be 1 mm or less.

According to one example, the curing the polymers may be curing only the polymers of some electronic devices selected by supplying power to only electrodes corresponding to some electronic devices among the plurality of electronic devices.

### ADVANTAGEOUS EFFECTS

The present invention has advantages of being able to coat polymers on numerous electronic devices at the same time in a single process by using a stamping process, and being able to actively coat polymers on electronic devices without restrictions by process variables such as electronic device size, and device gap. In addition, it has advantages of being able to recycle remaining polymers after stamping, which is advantageous for mass production and in repetitive processes.

Furthermore, according to the example of the present invention, substrate adhesion of defective electronic devices can be prevented without any special means, so automatic identification of defective electronic devices are possible, and selective substrate bonding among arrays can be achieved through selective light emission.

In addition, a stamping process that allows bonding of isolated polymers between each array even when the array gap has a fine pitch.

Moreover, even when a contact pat is introduced into an electronic device, polymers on the bottom of the contact pad is sufficiently cured, and thus, it can make electrical connection and physical bonding between an electrode and the electronic device possible.

In addition, it also has an advantage of being able to easily confirm whether each electronic device emits light during a process, by preparing the electronic devices using magnets placed on only one side.

Moreover, magnetically aligned ferromagnetic particles have anisotropic current flow in which only current in the aligned direction flows. Therefore, only up-down current flow is possible between electronic devices and electrodes, and no electrical short circuit occurs between surrounding LED devices and electrode, so it can respond to fine patterning.

The present invention is a technology with high added value because it can be applied without size restrictions from small displays to ultra-large displays. Accordingly, the electronic device can implement high resolution through a high level of integration, and thus, has high applicability to future displays such as AR, VR and vehicle displays, flexible and stretchable displays and the like.

The effects that can be obtained from the present invention are not limited to the effects mentioned above, and other effects that are not mentioned can be clearly understood by those skilled in the art to which the present invention pertains from the description below.

### BRIEF DESCRIPTION OF THE DRAWINGS

FIG. 1 is a flow chart of the transfer method of an electronic device according to one example of the present invention.
FIG. 2 and FIG. 3 are illustrative plans which schematically illustrate the prepared first substrate and the prepared second substrate.
FIG. 4 and FIG. 5 illustratively show the process of contacting the first substrate and the second substrate.
FIG. 6 illustratively shows the state in which polymers are coated on the electronic device array.
FIG. 7 is an illustrative plan which schematically shows the prepared third substrate.
FIG. 8 illustrates the state in which a magnetic field is formed for electrical connection between the polymers coated on the electronic device array of the first substrate in contact with the electrodes of the third substrate.
FIG. 9 and FIG. 10 illustrate the state in which the electronic devices are transferred into the third substrate according to the afore-mentioned transfer method.
FIG. 11 and FIG. 12 are the experimental design for experimenting whether polymers (resin) can be formed separately on each electronic device during the stamping process when there is the pitch (d) gap between the electronic devices of the array and the experimental photographs showing results thereof.
FIG. 13 and FIG. 14 are drawings and actual experimental photographs that show how polymers are coated in which form depending on the pitch gap between electronic devices and the approach speed between the polymers and electronic devices.
FIG. 15 shows the results experimented in FIG. 11 to FIG. 14 as a graph, and indicates whether polymer coating separated between electronic devices was successful depending on the pitch gap and the approach speed between electronic devices of the array.
FIG. 16 shows the results experimented in FIG. 11 to FIG. 14 as photographs, and shows the result of successful polymer coating separated between electronic devices depending on the pitch gap and approach speed between electronic devices of the array.
FIG. 17 and FIG. 18 show the results of enabling achieving the selective transfer process through selective light emission and polymer curing by selectively applying current to electrodes.
FIG. 19 to FIG. 21 are graphs showing the decreasing tendency of the magnetic field and magnetic flux formed when magnets on the top are removed and only magnets on the bottom are introduced.
FIG. 22 is an experimental image confirming that the light emission of electronic devices and polymer curing become possible under control of the appropriate thickness and appropriate current even when only magnets on the bottom are introduced.
FIG. 23 and FIG. 24 are schematic diagrams and actual photographs showing the phenomenon that occurs when there is no scattering particle and when the scattering particles is comprised in relation to curing of the polymers located on the bottom of the contact pad.

### MODE FOR INVENTION

Examples of the present disclosure are illustrated for the purpose of describing the technical spirit of the present disclosure. The scope according to the present disclosure are not limited to examples presented below or specific description of these examples.

All technical terms and scientific terms used in the present disclosure have meanings commonly understood by those skilled in the art to which the present disclosure belongs, unless otherwise defined. All terms used in the present disclosure are selected for the purpose of more clearly describing the present disclosure, and are not selected to limit the scope according to the present invention.

Expressions such as "comprising", "providing", "having" and the like used in the present disclosure, should be understood in open-ended terms encompassing the possibility of including other examples, unless otherwise stated in a phrase or sentence in which the corresponding expression is included.

Expressions in a singular form described in the present disclosure may include a meaning of a plural form unless otherwise stated, and this is equally applied to expressions in a singular form described in claims.

Hereinafter, with reference to the attached drawings, examples of the present invention will be described. In addition, in the description of the following examples, repeated description of identical or corresponding components may be omitted. However, even if description of a component is omitted, it is not intended that such component is not included in any example.

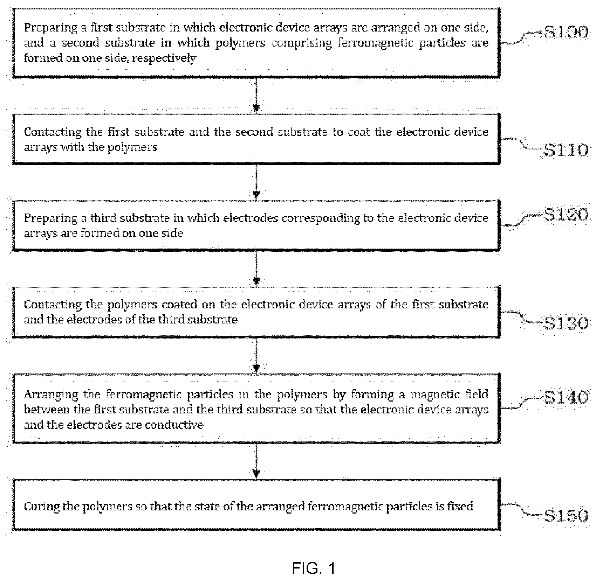

FIG. 1 is a flow chart of the transfer method of an electronic device according to one example of the present invention.

Referring to FIG. 1, the transfer method of an electronic device according to one example of the present invention comprises preparing a first substrate in which electronic device arrays are arranged on one side, and a second substrate in which polymers comprising ferromagnetic particles are formed on one side, respectively (S100); contacting the electronic device arrays of the first substrate and the polymers of the second substrate while controlling an approach speed, to coat the electronic device arrays with the polymers (S110); preparing a third substrate in which electrodes corresponding to the electronic device arrays are formed on at least one side (S120); contacting the polymers coated on the electronic device arrays of the first substrate and the electrodes of the third substrate (S130); arranging the ferromagnetic particles in the polymers by forming a magnetic field between the first substrate and the third substrate so that the electronic device arrays and the electrodes become conductive (S140); and curing the polymers so that the state of the arranged ferromagnetic particles is fixed (S150).

At first, a first substrate in which electronic device arrays are arranged on one side and a second substrate in which polymers comprising ferromagnetic particles are formed are prepared, respectively (S100).

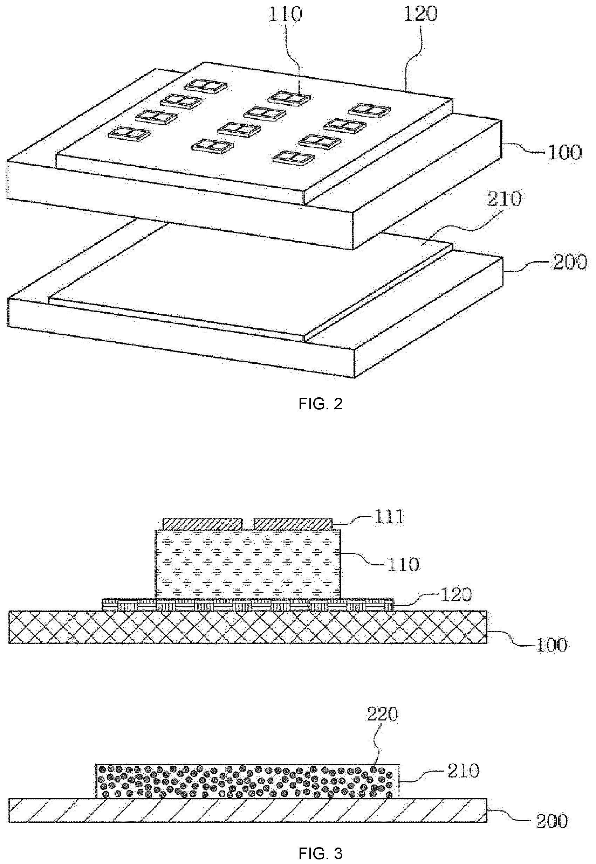

FIG. 2 and FIG. 3 are illustrative plans which schematically illustrate the prepared first substrate and the prepared second substrate. Specifically, FIG. 2 is a perspective view capable of confirming the overall composition of the first substrate and the second substrate, and FIG. 3 is a cross-sectional view for illustrating the relationship between components based on one electronic device (110).

Referring to FIG. 2 and FIG. 3, the first substrate (100) in which electronic device arrays (110) are arranged on one side. The first substrate (100) is in a state in which a plurality of electronic devices (110) are arranged in an array form. The plurality of electronic devices (110) illustrated in FIG. 2 and FIG. 3 correspond to one example, and the number and composition of the plurality of electronic devices (110) are not limited thereto.

The electronic device arrays (110) arranged in the first substrate (100) may be transferred into a substrate in which other components are formed for manufacturing electronic equipment once. The electronic device arrays (110) may be micro LED devices. Herein, the micro LED devices generally refer to devices smaller than 100 µm × 100 µm (width × height). However, it is not limited thereto, the transfer method of an electronic device according to the example of the present invention may be applied to not only various sizes and types of micro LED devices (lateral, vertical), bust also other microelectronic devices.

The first substrate (100) may be a glass substrate, but not limited thereto. The first substrate (100) may be a carrier substrate for delivering the electronic device arrays (110) into another substrate, and may be removed after completing the process described below. The first substrate (110) and electronic device arrays (100) may be temporarily connected through an adhesion layer (120). In addition, each electronic device (110) may comprise a contact pad (111) for electrical connection.

The second substrate (200) in which polymers (210) comprising ferromagnetic particles (220) are formed on one side is prepared. The second substrate (200) may be a glass substrate, but not limited thereto. Through blade coating and the like, the polymers (210) may be applied on one side of the second substrate (200). The polymers (210) may be formed on one side of the second substrate (200) to have an area corresponding to the total area of the electronic device arrays (110). Illustratively, the total area of the polymers (210) may be broader than the total area of the electronic device arrays (110).

The polymers (210) coated on one side of the second substrate (200) may be anisotropic conductive adhesives (ACA). In other words, the polymers (210) correspond to substances which can provide mechanical properties and processibility of polymers together with electrical, magnetic, and optical properties of metals by mixing metal particles to a polymer binder. The polymers (210) may be curable polymers, and the current shape may be fixed by being cured under certain temperature conditions or a specific wavelength. Through the polymers (210), physical connection and bonding between other components may be possible. In other words, the polymers (210) may provide an adhesive function that fixes the electronic devices (110) to other components.

The ferromagnetic particles (220) distributed in the inside of the polymers (210) are metal particles, and may provide electrical, magnetic and optical properties of metals. In other words, through the ferromagnetic particles (220), electrical connection between other components may be possible. In addition, the ferromagnetic particles (220) are particles largely affected by an external magnetic field, and the internal location of the polymers may be changed depending on the direction of the external magnetic field. In other words, the arrangement direction of the ferromagnetic particles (220) inside the polymers (210) may be determined by the external magnetic field.

Next, the polymers are coated on the electronic device arrays by contacting the electronic device arrays of the first substrate and the polymers of the second substrate (S110).

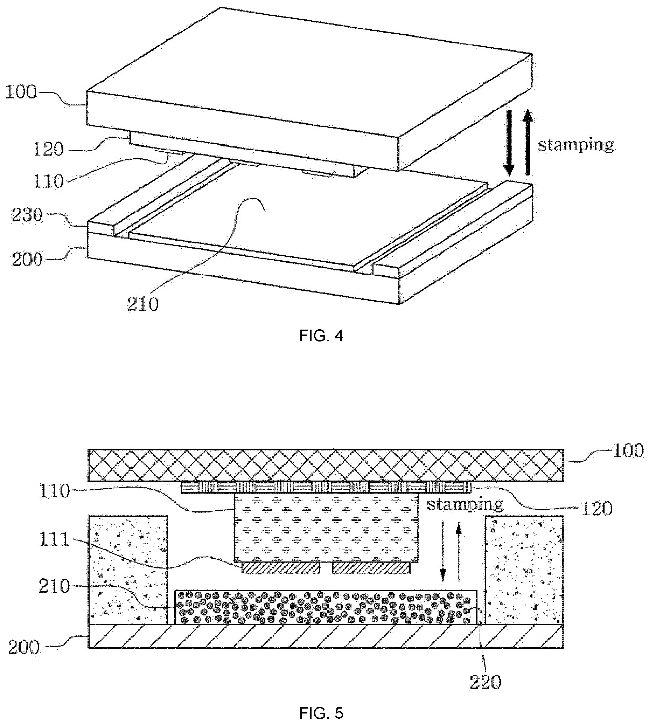

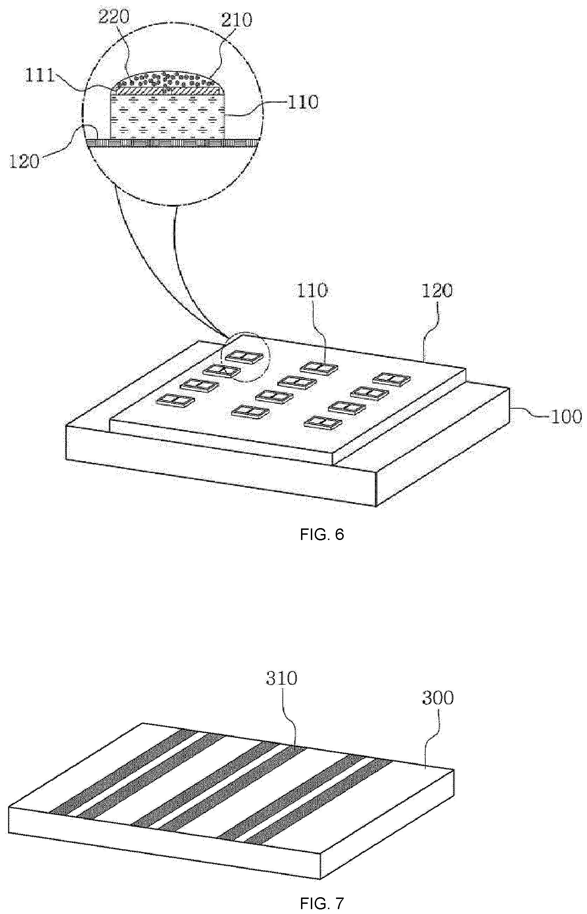

FIG. 4 and FIG. 5 illustratively show the process of contacting the first substrate and the second substrate, and FIG. 6 illustratively shows the state in which polymers are coated on the electronic device array. Specifically, FIG. 4 is a perspective view capable of confirming the overall components of the first substrate and the second substrate, and FIG. 5 is a cross-sectional view for describing the relationship of components based on one electronic device (110).

Referring to FIG. 4 and FIG. 5, one side of the first substrate (100) and one side of the second substrate (200) may be positioned to face each other. In other words, the first substrate (100) and the second substrate (200) may be positioned so that the electronic device arrays (110) of the first substate (100) and the polymers (210) of the second substrate (200) face each other. While positioned to face each other, at least one of the first substrate (100) and the second substrate (200) may be vertically moved so that the distance therebetween becomes shorter. As the distance between the first substrate (100) and the second substrate (200) becomes shorter, the electronic device arrays (110) of the first substrate (100) and the polymers (210) of the second substrate (200) may come into contact. According to the above contact, the polymers (210) are coated on the electronic device arrays (110) of the first substrate (100). In other words, some of the polymers (210) of the second substrate (200) are combined with the electronic device arrays (110) and moved. After the polymers (210) in a certain period of time or in a sufficient amount are moved to the surfaces of the electronic device arrays (110), at least one of the first substrate (100) and the second substrate (200) is vertically moved, so that the distance between the first substrate (100) and the second substrate (200) becomes distant.

Through the stamping process as the process described above, as the electronic device arrays (110) of the first substrate (100) and the polymers (200) of the second substrate (220) come into contact, the polymers (210) of the second substrate (200) may selectively move to the electronic device arrays (110) of the first substrate (100).

Referring to FIG. 6, it can be confirmed that the polymers (210) of the electronic device arrays (110) are coated so that the polymers (210) cover the entire contact pad (111) of the electronic device arrays (110). In addition, the polymers (210) have an area corresponding to the total area of the electronic device arrays (110) or an area capable of covering the total area of the electronic device arrays (110), and thus, all electronic devices comprised in the electronic device arrays (110) are coated with the polymers (210) in one stamping process. In other words, there is no need for an individual coating process for fine-sized electronic devices comprised in the electronic device arrays (110), and it is possible to coat and apply the polymers (210) for physical and electrical bonding of electronic devices in one stamping process.

Herein, the second substrate (200) may further comprise a spacer (230) limiting the contact distance with the first substrate (100). The spacer (230) may be formed on one side of the second substrate (200), and may be formed in a region corresponding to the outside of the polymers (210). Exemplarily, the spacer (230) may be formed to correspond to an edge region or corner region of the second substrate (200), but not limited thereto. The spacer (230) may be formed to have a certain height. By this spacer (230), conditions under which the stamping process of the first substrate (100) and the second substrate (200) is performed may be limited. The distance at which the first substrate (100) and the second substrate (200) approach each other, the distance for contact may be limited by the height of the spacer (230). In other words, the degree in which the electronic device arrays (110) and the polymers (210) are in contact, the degree in which the polymers (210) are coated may be determined by the spacer (230). In addition, that the first substrate (100) and the second substrate (200) approach closely may be prevented by the spacer (230), thereby preventing the electronic device arrays (110) from being damaged by the stamping process.

Then, the third substrate in which electrodes corresponding to the electronic device arrays are formed on one size is prepared (S120).

FIG. 7 is an illustrative plan which schematically shows the prepared third substrate.

Referring to FIG. 7, the third substrate (300) in which electrodes (310) corresponding to at least electronic device arrays (110) are formed is prepared. The third substrate (300) may be a substrate further comprising components necessary for operation of electronic devices. In other words, the third substrate (300) corresponds to a substrate to which electronic devices are delivered from the first substrate (100), which is a carrier substrate. The third substrate (300) may be a glass substrate, but not limited thereto. The third substrate (300) may be a flexible substrate. For example, the third substrate (300) may be composed of plastic or silicone rubber. In other words, it may become easier to implement a flexible display or stretchable display, by transferring electronic devices on a flexible substrate by the transfer method according to the example of the present invention.

The electrodes (310) may optimize the desired pattern size and gap using inkjet printing technology, and a photo process using a mask may also be applied.

Next, the electronic device arrays (110) of the first substrate (100) may be transferred into the third substrate (300). The electronic device arrays (110) of the first substrate (100) may be physically and electrically connected with the corresponding third substrate (300) by being transferring to the third substrate (300). Such a transfer process is performed by contacting polymers coated on electronic device arrays of the first substrate and with electrodes of the third substrate (S130); arranging the ferromagnetic particles in the polymers so that the electronic device arrays and the electrodes become conductive by forming a magnetic field between the first substrate and the third substrate (S140); and curing the polymers so that the state of the arranged ferromagnetic particles is fixed (S150).

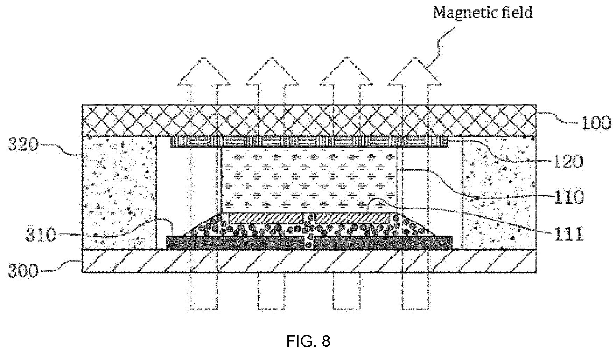

FIG. 8 illustrates the state in which a magnetic field is formed for electrical connection between the polymers coated on the electronic device array of the first substrate in contact with the electrodes of the third substrate. FIG. 8 exemplarily illustrates a pair of electrodes (310) corresponding to one electronic device (110), but the process described below simultaneously occurs between the electronic device arrays (110) of the first substrate (100) and the electrodes (310) of the third substrate (300). In other words, as one process is performed, the electronic device arrays (110) of the first substrate (100) are easily transferred into the third substrate (300), and physical and electrical connection between them is also performed.

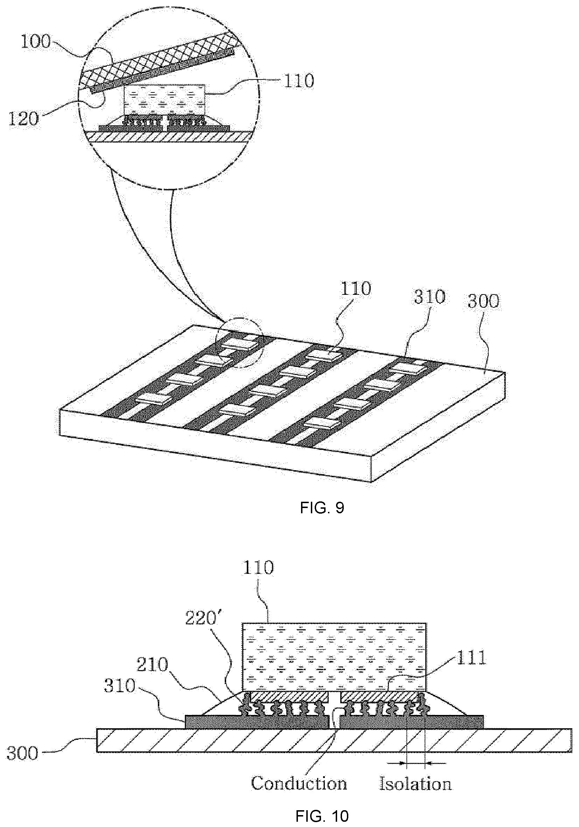

As shown in FIG. 8, the electronic device arrays (110) of the first substrate (100) may be positioned so as to face the corresponding electrodes (310) of the third substrate (300). FIG. 9 and FIG. 8 illustrate the state in which the electronic devices are transferred into the third substrate according to the afore-mentioned transfer method.

The polymers (210) coated on the electronic device arrays (110) of the first substrate (100) and the electrodes (310) of the third substrate (300) may be positioned to face to each other, and as at least one of the first substrate (100) and the third substrate (300) moves, the coated polymers (210) and electrodes (310) become in contact. The first substrate (100) and the third substrate (300) may become close so that the polymers (210) can sufficiently move to the electrodes (310). The third substrate (300) may further comprise a spacer (320) that limits such a distance between the first substrate (100) and the third substrate (300), and maintains a certain gap between the first substrate (100) and the third substrate (300). However, it is not limited thereto, in addition to the method of sandwiching a material with a specific height between two substrates, a proper gap between the two substrates may be made also by mechanical equipment capable of controlling movements finely.

In a state in which the polymers (210) sufficiently move to the electrodes (310), a magnetic field is formed between the first substrate (100) and the third substrate (300) and ferromagnetic particles (220) in the polymers (210) are arranged so that the electronic device arrays (110) and the electrodes (310) become conductive. An electrode for forming a magnetic field may be placed on the bottom of the first substrate (100) and the top of the third substrate (300), and a magnetic field may be formed in a vertical direction. The position of the ferromagnetic particles (220) is rearranged in the polymers (210) to correspond to the direction of the formed magnetic field. In other words, the ferromagnetic particles (220) may be self-aligned in the polymers (210) depending on the magnetic field. For example, the ferromagnetic particles (220) are self-aligned in a vertical direction in the polymers (210) depending on the magnetic field formed in a vertical direction. The ferromagnetic particles rearranged in the vertical direction have a pillar shape, and the contact pad (111) of the electronic device arrays (110) and the electrodes (310) are electrically connected to each other by the rearranged ferromagnetic particles.

The polymers (210) may be cured so that the state and shape of the rearranged ferromagnetic particles. When the formed magnetic field is removed, the position of the ferromagnetic particles (220) may be changed again in the polymers (210). In order to prevent such movement of the ferromagnetic particles (220) in the polymers (210), the polymers (210) are cured. As the state of the ferromagnetic particles (220) rearranged through curing of the polymers (210) is continuously maintained, the electrical connection of the electronic device arrays (110) and electrodes (310) may be continuously maintained. In other words, the state in which electrical flow in a vertical direction is fixed, and the ferromagnetic pillar aligned in the magnetic field direction has anisotropic conductive properties, and therefore, no electrical short-circuit occurs between the electrodes and devices.

Furthermore, through curing the polymers (210), the electronic device arrays (110) and electrodes (310) may be physically connected. In other words, through the polymers (210), the electronic device arrays (110) may be physically fixed on the third substrate (300). The polymers (210) may be heat-curable polymers which are cured depending on a certain temperature condition, and the step (S150) may comprise curing the polymers (210) by maintaining a certain temperature for a certain period of time in a state in which a magnetic field is formed. However, it is not limited thereto, the polymers (210) may be photo-curable polymers which are cured by a specific wavelength, and the step (S150) may comprise curing the polymers (210) by irradiating lights of a wavelength band for curing for a certain period of time in a state in which a magnetic field is formed.

In addition, the step (S150) may further comprise transmitting pressure into the first substrate (100) and the third substrate (300) in a vertical direction to compressing so that the vertical distance between the first substrate (100) and the third substrate (300) becomes closer. Through the compressing, physical connection of the electronic device arrays (110) and electrodes (310) by the polymers (210) may be performed more efficiently.

After the curing (S150) the polymers so that the state of the arranged ferromagnetic particles is fixed, detaching the first substrate (100) from the electronic device arrays (110) by removing connection of the adhesive layer (120) and the electronic device arrays (110) is performed. Accordingly, the electronic device arrays (110) is completely transferred into the third substrate (300).

As shown in FIG. 9, it can be confirmed that the corresponding electronic device arrays (110) comprised in the conventional first substrate (100) are transferred into the third substrate (300), and are positioned on the corresponding electrodes (310). In addition, as shown in FIG. 10, it can be confirmed that the ferromagnetic particles (220') arranged in the polymers (210) are connected to the electrodes (310) and the contact pad (111) of the electrode device arrays (110), respectively, thereby enabling electrical connection therebetween.

The electronic equipment according to other example of the present invention may comprise electronic devices transferred through the transfer method according to the afore-mentioned FIG. 1 to FIG. 10. The schematic composition of the electronic equipment can be confirmed in FIG. 9 and FIG. 10. Specifically, the electronic equipment according to the present invention may comprise a substrate (300); electrodes (310) formed on the substrate; electronic devices (110) electrically connected to the electrodes (310); and cured polymers (210) positioned between the electrodes and the electronic devices, and the cured polymers (210) may comprise a plurality of ferromagnetic particles (220') arranged along one direction, and the electrodes (310) and the electronic devices (110) may be electrically connected through the plurality of ferromagnetic particles (220'). Herein, the electronic devices (110) may be micro LEDs.

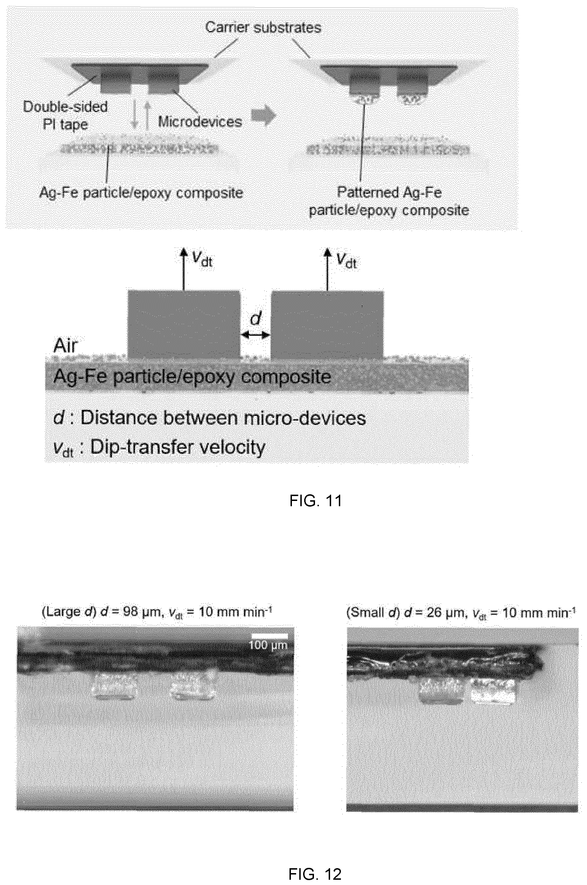

FIG. 11 and FIG. 12 are the experimental design for experimenting whether polymers (resin) can be formed separately on each electronic device during the stamping process when there is the pitch (d) gap between the electronic devices of the array and the experimental photographs showing results thereof.

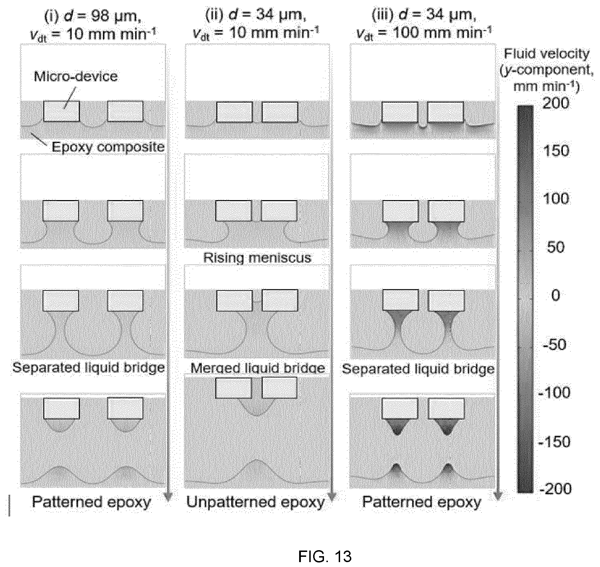

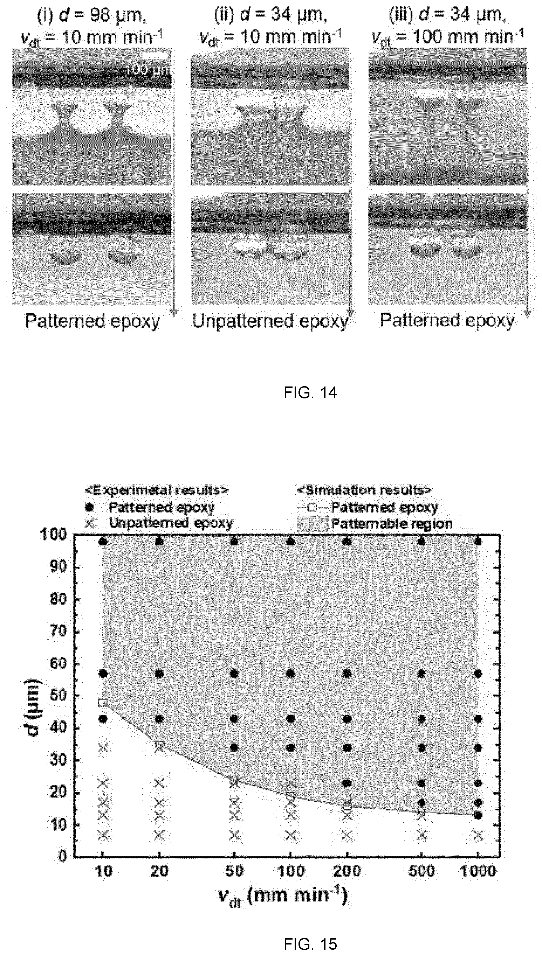

FIG. 13 and FIG. 14 are drawings and actual experimental photographs that show how polymers are coated in which form depending on the pitch gap between electronic devices and the approach speed between the polymers and electronic devices.

FIG. 15 shows the results experimented in FIG. 11 to FIG. 14 as a graph, and indicates whether polymer coating separated between electronic devices was successful depending on the pitch gap and the approach speed between electronic devices of the array.

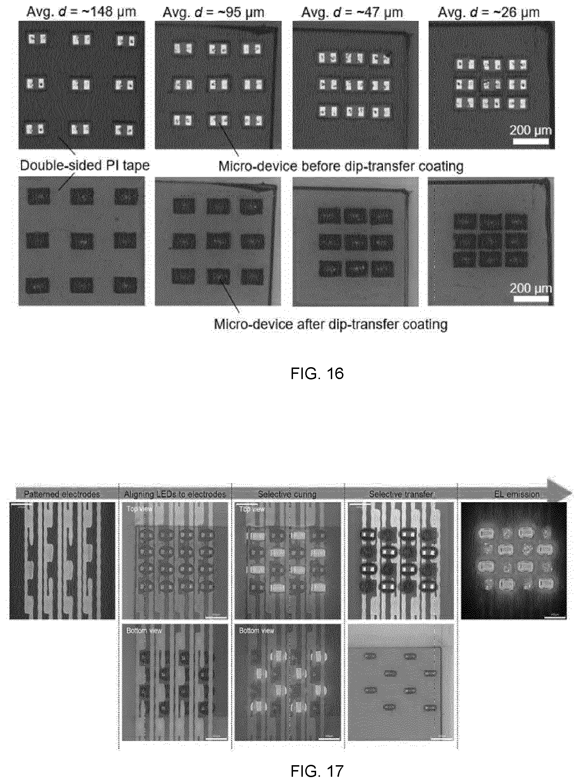

FIG. 16 shows the results experimented in FIG. 11 to FIG. 14 as photographs, and shows the result of successful polymer coating separated between electronic devices depending on the pitch gap and approach speed between electronic devices of the array.

Referring to FIG. 11 to FIG. 16, it can be confirmed that separated polymers on each electronic device can be formed using the stamping process, when the approach speed is controlled at an appropriate speed, even when the pitch gap of the electronic devices forming micro LED arrays are finely formed. Through this, it can be confirmed that there will be no problem of being electrically connected as the polymers are connected to each other between each electronic device.

The present inventors have confirmed that it is impossible to form a separated polymer formation according to the micro-sized electronic devices and fine pitch gap between them, when approaching with only a simple idea of the stamping process, thereby completing the present invention through several times of designs and repeated experiments. Through this, the present inventors can confirm that polymer coating separated by each electronic device can be formed through the stamping process even when the gap between the electronic devices is 100 µm or less. The gap between the electronic devices may be 5 µm or more. In addition, the gap between the electronic devices may be 50 µm or less. Preferably, the gap between the electronic devices may be 35 µm or less.

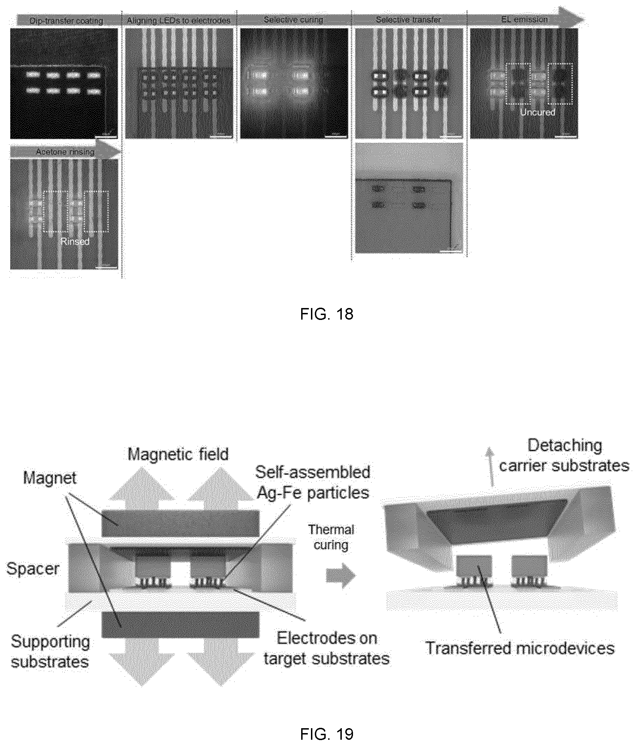

FIG. 17 and FIG. 18 show the results of enabling achieving the selective transfer process through selective light emission and polymer curing by selectively applying current to electrodes.

Referring to FIG. 17 and FIG. 18, in can be seen that selective electronic device bonding can be achieved while a substrate in which the same electronic device arrays are formed, in the manufacturing process of a micro LED, and this means that it can be used in the electronic device transfer process of various methods as well as the repair process.

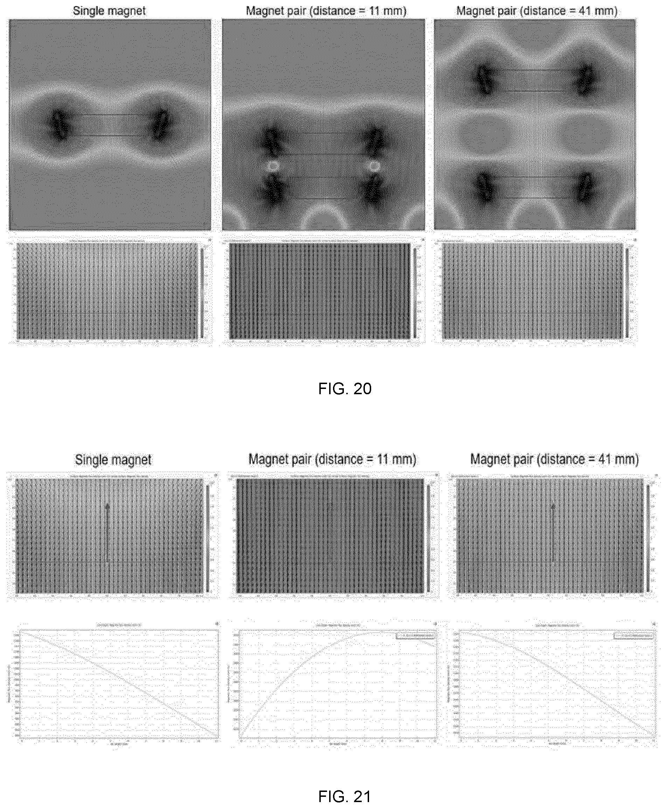

FIG. 19 to FIG. 21 are graphs showing the decreasing tendency of the magnetic field and magnetic flux formed when magnets on the top are removed and only magnets on the bottom are introduced.

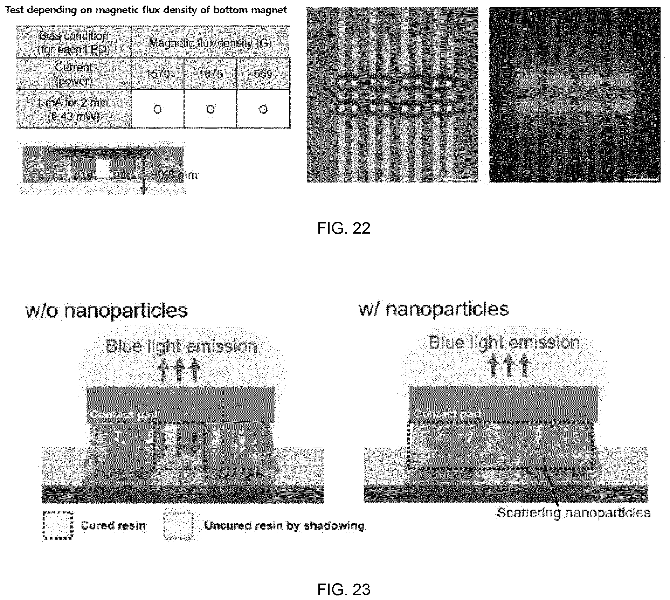

FIG. 22 is an experimental image confirming that the light emission of electronic devices and polymer curing become possible under control of the appropriate thickness and appropriate current even when only magnets on the bottom are introduced.

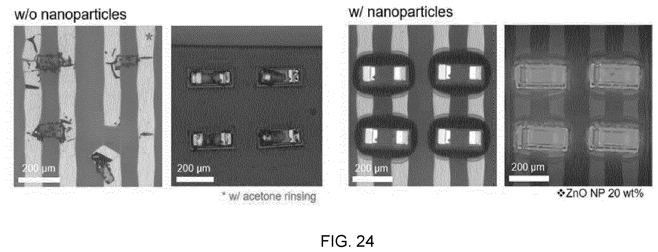

FIG. 23 and FIG. 24 are schematic diagrams and actual photographs showing the phenomenon that occurs when there is no scattering particle and when the scattering particles is comprised in relation to curing of the polymers located on the bottom of the contact pad.

Referring to FIG. 22 to FIG. 24, it can be confirmed that the ferromagnetic particles in the polymers of the electronic device arrays in a micro LED thickness can be arranged in any degree only by introducing a magnet part on one side in the process. Through this, there are advantages of being able to promote efficiency and convenience of the process, but also of being able to easily confirm whether light enters each light emitting device during the process and whether polymer curing occurs well through this.

In the present invention, the scattering particle is not particularly limited as long as it is a particle capable of scattering light that can cure polymers. The scattering particle may be a nanoscale particle. The scattering particle may be metal oxide, and as one example, the scattering particle may be transparent metal oxide. In addition, the scattering particle may be at least one selected from the group consisting of TiO₂, SiO₂, ZnO, Al₂O₃, BaSO₄, CaCO₃ and ZrO₂.

In this way, the present invention proposes an electronic device (micro LED) transfer process technology, and therefore, it is expected to be widely used in fields such as smart fibers in which fibers and LED are combined, medical devices for human body attachment or insertion, bio contact lens, HMD, automobiles and the like, in addition to conventional small to large displays and next-generation displays beyond them.

The present invention examined above has been described with reference to examples illustrated in the drawings, but these are only illustrative, and those skilled in the art can understood that various modifications therefrom and modifications of the examples are possible. However, such modifications should be considered to be within the technical scope of the present invention. Therefore, the true technical scope of the present invention should be determined by the technical spirit of the attached claims.

## Claims

1. A micro LED array electronic device comprising a plurality of light emitting devices arranged in columns and rows,
which comprises two electrodes formed extending in one direction on a substrate; and
cured polymers that fill the gap between the electrodes and vertically spaced electronic devices and comprises ferromagnetic particles,
wherein the gap between the plurality of electronic devices is 5 µm or more and 100 µm or less.

2. The micro LED array electronic device according to claim 1,
wherein the gap between the electronic devices is 35 µm or less.

3. The micro LED array electronic device according to claim 1,
further comprising two contact pads formed on the electrode direction surface of the light emitting devices,
wherein the polymers further comprise dispersed scattering nanoparticles.

4. The micro LED array electronic device according to claim 3,
wherein the scattering nanoparticles
comprise metal oxide.

5. The micro LED array electronic device according to claim 3,
wherein the scattering nanoparticles are at least one selected from the group consisting of TiO₂, SiO₂, ZnO, Al₂O₃, BaSO₄, CaCO₃ and ZrO₂.

6. The micro LED array electronic device according to claim 1,
wherein the ferromagnetic particles are oriented and arranged to electrically connect the electrodes and the light emitting devices.

7. The micro LED array electronic device according to claim 1,
wherein the thickness from the substrate to the electronic devices is 1 mm or less.

8. The micro LED array electronic device according to claim 7,
wherein the polymer curing of the electronic devices is performed with a single magnet located at the bottom of the substrate.

9. The micro LED array electronic device according to claim 1,
wherein the lateral surface area of the electronic devices is smaller than the sum of the lateral surface areas of the two electrodes.

10. A manufacturing method of a micro LED electronic device, comprising
preparing a first substrate in which a plurality of electronic device arrays are arranged on one side, and a second substrate in which polymers comprising ferromagnetic particles are formed on one side, respectively;
contacting the electronic device arrays of the first substrate and the polymers of the second substrate while controlling an approach speed, to coat the electronic device arrays with the polymers;
preparing a third substrate in which electrodes corresponding to the electronic device arrays are formed on at least one side;
contacting the polymers coated on the electronic device arrays of the first substrate and the electrodes of the third substrate;
arranging the ferromagnetic particles in the polymers by forming a magnetic field between the first substrate and the third substrate so that the electronic device arrays and the electrodes are electrically connected; and
curing the polymers so that the state of the arranged ferromagnetic particles is fixed,
wherein the gap between the plurality of electronic devices is 5 µm or more and 100 µm or less.

11. The manufacturing method of a micro LED electronic device according to claim 10,
wherein the approach speed is 10 mm/min to 1500 mm/min.

12. The manufacturing method of a micro LED electronic device according to claim 11,
wherein the approach speed is 50 mm/min or more.

13. The manufacturing method of a micro LED electronic device according to claim 10,
further comprising; mixing scattering particles to the polymers before the coating the polymers,
wherein the light emitting devices further comprise a contact pad on the bottom.

14. The manufacturing method of a micro LED electronic device according to claim 10,
wherein the arranging the ferromagnetic particles
is performed using a magnet placed only on either the bottom of the third substrate or the top of the first substrate.

15. The manufacturing method of a micro LED electronic device according to claim 14,
wherein the arranging the ferromagnetic particles
is performed without placing a magnet on the top of the first substrate.

16. The manufacturing method of a micro LED electronic device according to claim 14,
wherein the thickness from the substrate to the electronic devices is 1 mm or less.

17. The manufacturing method of a micro LED electronic device according to claim 14,
wherein the curing the polymers is
curing only the polymers of some electronic devices selected by supplying power to only electrodes corresponding to some electronic devices among the plurality of electronic devices.
